# EUROPEAN PATENT SPECIFICATION

(11) **EP 2 824 214 B1**
(45) Date of publication and mention of the grant of the patent: **30.08.2017**
(21) Application number: 14176149.4
(22) Date of filing: 08.07.2014
(51) Int. Cl.: C23C 4/02, C23C 28/04, C23C 28/00, C23C 14/02, F02C 7/232, C23C 14/06, F16K 3/24, F16K 25/00

(54) **Coating arrangement for fuel control metering valve and method**
Beschichtungsanordnung für Kraftstoffeinspritzregelventil und Verfahren
Système de revêtement pour soupape de dosage et procédé

(30) Priority: 10.07.2013 US 201361844599 P; 28.02.2014 US 201414193145
(43) Date of publication of application: 14.01.2015
(73) Proprietor: Hamilton Sundstrand Corporation, Charlotte, NC 28217 (US)
(72) Inventor: Rankin, Kevin M., Windsor, CT Connecticut 06095 (US); Ballard, Peter M., Enfield, CT Connecticut 06082 (US)
(74) Representative: Hughes, Andrea Michelle

(56) References cited:
- DE-A1-102008 031 690
- JP-A- S5 633 471
- JP-A- 2005 061 244
- F. MAJDIC ET AL: "Improving the performance of a proportional 4/3 water-hydraulic valve by using a diamond-like-carbon coating", WEAR, vol. 297, no. 1-2, 1 January 2013 (2013-01-01), pages 1016-1024, XP055154648, ISSN: 0043-1648, DOI: 10.1016/j.wear.2012.11.060

## Description

### CROSS-REFERENCE TO RELATED APPLICATIONS

### BACKGROUND OF THE INVENTION

The present invention relates to sliding actuator assemblies, and more particularly to coating arrangements for fuel control metering valves, as well as a method of coating such components.

Various sliding applications, such as valve assemblies, for example, employ a spool-in-sleeve configuration. These applications are often manufactured from hardened steel primarily for wear resistance. Significant weight savings could be realized by constructing spool and sleeve components from non-steel materials. Valve assemblies, such as metering valves and pressure regulating valves, experience small-amplitude dither motion throughout their normal operation which leads to more aggressive wear, thereby typically necessitating self-mated steel configurations. Coatings applied directly on softer, non-steel materials often experience a failure mode in which local high contact stress causes deformation of soft substrates since the coating is very thin.

DE102008031690 discloses a fuel control metering valve of steel having a sleeve (28, 32) and a spool (30) of hardened steel, with two DLC layers.

### BRIEF DESCRIPTION OF THE INVENTION

According to one embodiment, a coated valve assembly according to claim 1 is claimed.

According to another embodiment, a method of coating components according to claim 9 is claimed.

### BRIEF DESCRIPTION OF THE DRAWINGS

The subject matter which is regarded as the invention is pointed out and distinctly claimed in the claims at the conclusion of the specification. The foregoing and other features and advantages of the invention are apparent from the following detailed description taken in conjunction with the accompanying drawings in which:
FIG. 1 is a sectional illustration of a first type of valve assembly;
FIG. 2 is a perspective view of a spool of the first type of valve assembly of FIG. 1;
FIG. 3 is a perspective view of a sleeve of the first type of valve assembly of FIG. 1;
FIG. 4 is a sectional illustration of a second type of valve assembly;
FIG. 5 is a perspective view of a sleeve of the second type of valve assembly of FIG. 4;
FIG. 6 is a perspective view of a spool of the second type of valve assembly of FIG. 4;
FIG. 7 is a cross-sectional view of a coating arrangement according to a first embodiment;
FIG. 8 is a cross-sectional view of the coating arrangement according to a second embodiment;
FIG. 9 is a cross-sectional view of the coating arrangement according to a third embodiment; and
FIG. 10 is a flow diagram illustrating a method of coating components of a valve assembly.

### DETAILED DESCRIPTION OF THE INVENTION

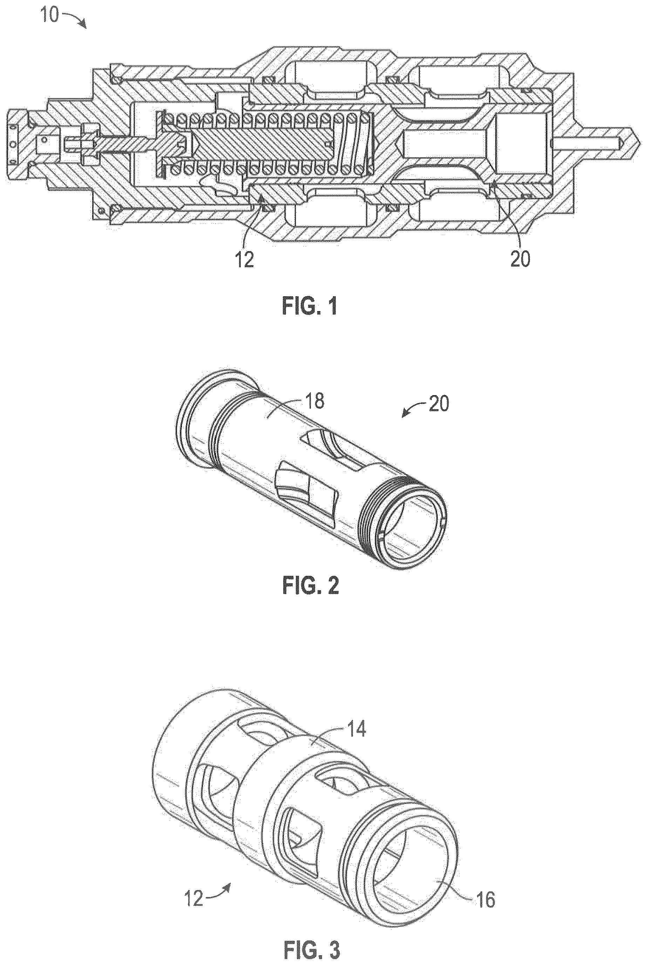

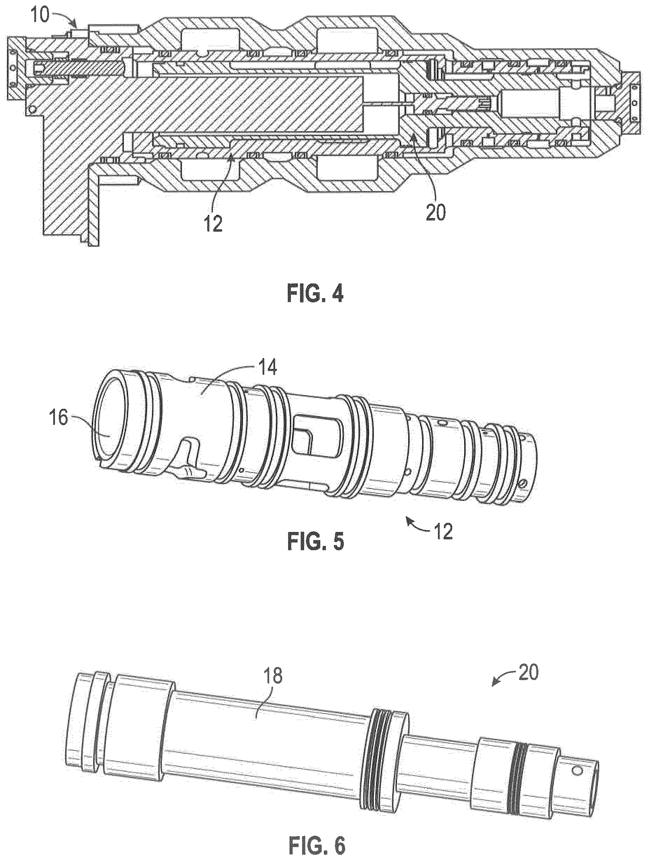

Referring to FIG. 1, a section of a valve assembly 10 is shown. The valve assembly 10 illustrated in FIG. 1 comprises a first type of valve assembly, while a second type of valve assembly is illustrated in FIG. 4. The first type of valve assembly is a pressure regulating valve not in accordance with the invention and the second type is a fuel control metering valve according to the invention. The valve assemblies illustrated are merely exemplary embodiments of the valve assembly 10 and it is to be appreciated that any type of valve assembly may benefit from the embodiments described herein. Furthermore, it is contemplated that any sliding application having components with relative sliding motion between the components may be employed, particularly those with lightly-loaded applications having conformal contact surfaces with geometry that prevents high contact stress (e.g., from edge loading), and where low-friction and resistance to sliding and fretting wear are desirable.

Referring now to FIGS. 1-6, the valve assembly 10 according to the two types described above is shown with FIGS. 2, 3, 5 and 6 showing individual components of the valve assembly 10. Specifically, the valve assembly 10 includes a sleeve 12 having a sleeve outer surface 14 and a sleeve inner surface 16. The geometry of the sleeve inner surface 16 may vary, but generally corresponds to a spool outer surface 18 of a spool 20 configured to be at least partially disposed within the sleeve 12. The sleeve 12 and the spool 20 are arranged to slide relative to each other during operation of the valve assembly 10. In order to reduce the weight of the overall valve assembly 10, the sleeve 12 and the spool 20 are formed of a non-steel material. The relatively softer and lighter material according to the invention is aluminum.

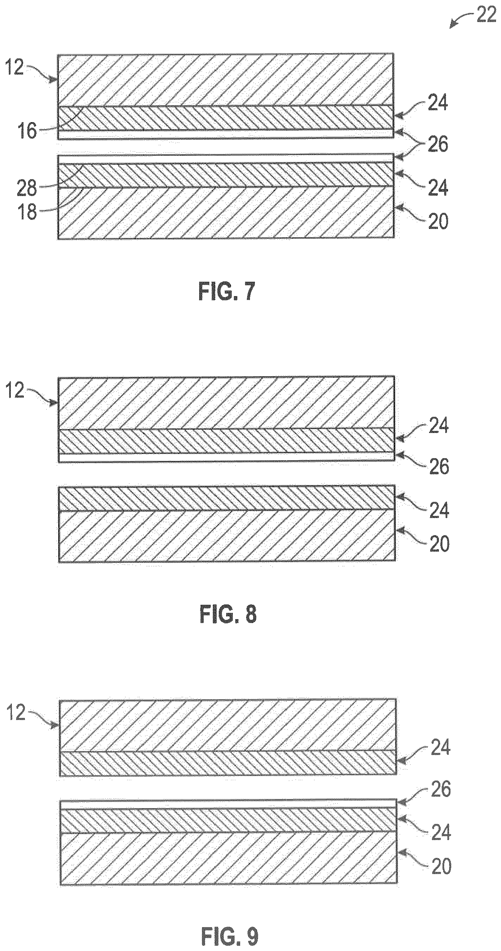

Referring to FIGS. 7-9, the sleeve inner surface 16 and the spool outer surface 18 are substrates for a coating arrangement 22 to be formed along the respective surfaces. The coating arrangement 22 may be arranged in numerous embodiments, as illustrated and described below.

The coating arrangement 22 includes a hardened surface 24 formed on the sleeve inner surface 16 and the spool outer surface 18. The hardened surface 24 may be formed by application of a coating or by any surface modification (e.g., machining) technique that increases the hardness of the sleeve inner surface 16 and the spool outer surface 18. In an embodiment having a coating, such as a base coating, as the hardened surface 24, a thermal spray coating or the like may be applied, for example. Machined surfaces may be formed in any suitable manner, such as plating, for example. Regardless of the particular manner in which the hardened surface 24 is formed, the hardened surface 24 is applied and/or machine finished to a surface roughness of less than or equal to about 0.0001016 mm (0.00004 inches). In an exemplary embodiment, the hardened surface 24 comprises a hardened surface thickness of about 0.0254 mm (0.001 inches) to about 0.254 mm (0.010 inches).

Upon completion of the formation of the hardened surface 24, a coating 26 is applied along an outer surface 28 of the hardened surface 24 to effectively form a second coating layer of the coating arrangement 22. In one embodiment (FIG. 7), the coating 26 is applied to the hardened surface 24 of both the sleeve inner surface 16 and the spool outer surface 18. In alternative embodiments (FIGS. 8 and 9), the coating 26 is applied to the hardened surface 24 of only one of the surfaces. In other words, the hardened surface 24 of either the sleeve inner surface 16 and the spool outer surface 18 is coated with the coating 26, while the other is left uncoated.

The coating 26 comprises a diamond-like carbon (DLC) coating that may be applied to the hardened surface 24 in a number of ways. The DLC coating may be applied by physical vapor deposition and the precise thickness of the DLC coating may vary depending on the application. In one embodiment, the coating 26 comprises a coating thickness of about 0.00127 mm (0.000050 inches) to about 0.00635 mm (0.000250 inches).

The thickness range of the hardened surface 24 specified above provides a substrate that is well-suited for bonding of the coating 26. In contrast to direct application of the coating 26 to a soft material, which is prone to flaking and general removal, the coating 26 of the above-described coating arrangement 22 is configured to adhere to the hardened surface in a durable manner.

Advantageously, the DLC coating provides a hard, low-friction surface to resist wear, and is particularly appropriate for the sliding applications described above, such as the types of the valve assembly 10 illustrated and described herein. This is based on the tightly controlled conformal contact surfaces and low contact loads.

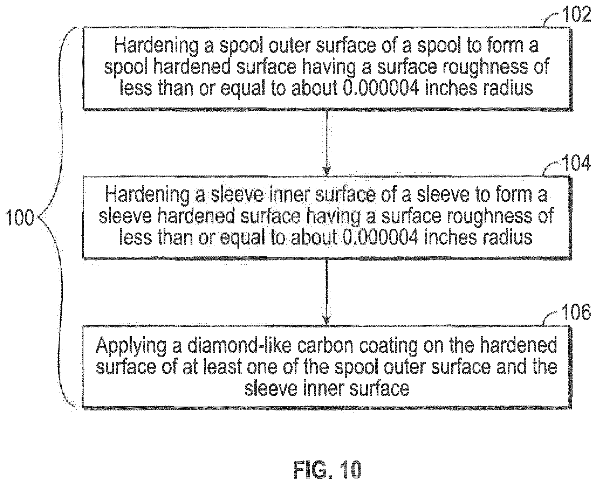

A method of coating components of a valve assembly 100 is also provided, as illustrated in FIG. 10 and with reference to FIGS. 1-9. The valve assembly 10 and the coating arrangement 22 have been previously described and specific structural components need not be described in further detail. The method of coating components of a valve assembly 100 includes hardening 102 the spool outer surface 18 of the spool 20 to a spool hardened surface having a surface roughness of about 0.0001016 mm (0.000004 inches). Additionally, the sleeve inner surface 16 of the sleeve 12 is hardened 104 to a sleeve hardened surface having a surface roughness of about 0.0001016 mm (0.000004 inches). A diamond-like carbon coating is applied 106 on the hardened surface of at least one of the spool outer surface 18 and the sleeve inner surface 16.

The numerous techniques that may be employed to form the hardened surfaces of the sleeve inner surface 16 and the spool outer surface 18 are described in detail above. Additionally, as noted above, the coating 26 may be applied by a physical vapor deposition process. Both the hardened surfaces and the coating 26 are formed to the dimensions described in detail above and the coating 26 may be applied to one or both of the hardened surfaces.

While the invention has been described in detail in connection with only a limited number of embodiments, it should be readily understood that the invention is not limited to such disclosed embodiments. Accordingly, the invention is not to be seen as limited by the foregoing description, but is only limited by the scope of the appended claims.

## Claims

1. A coated valve assembly (10) comprising:
a sleeve (12) having a sleeve outer surface (14) and a sleeve inner surface (16);
a spool (20) having a spool outer surface (18);
a hardened surface (24) formed on the sleeve inner surface (16) and the spool outer surface (18); and
a coating (26) disposed on the hardened surface of at least one of the spool outer surface (18) and the sleeve inner surface (16), the coating comprising a diamond-like carbon coating; wherein
at least one of the sleeve (12) and the spool (20) are formed of a material comprising aluminum; and wherein
the hardened surface (24) comprises a base coating; and wherein
the coated valve assembly (10) comprises a fuel control metering valve.

2. The coated valve assembly of claim 1, wherein the coating (26) is only disposed on the sleeve inner surface (16).

3. The coated valve assembly of claim 1, wherein the coating (26) is only disposed on the spool outer surface (18).

4. The coated valve assembly of claim 1, wherein the coating (26) is disposed on both the sleeve inner surface (16) and the spool outer surface (18).

5. The coated valve assembly of claim 1, wherein the hardened surface (24) comprises a hardened surface thickness of 0.0254 mm (0.001 inches) to 0.254 mm (0.010 inches).

6. The coated valve assembly of claim 1, wherein the hardened surface (24) comprises a surface roughness of less than or equal to 0.000004 inches (0.0001016 mm).

7. The coated valve assembly of claim 1, wherein the coating (26) comprises a coating thickness of 0.00127 mm (0.000050 inches) to 0.00635 mm (0.000250 inches).

8. The coated valve assembly of claim 1, wherein the base coating comprises a thermal spray coating.

9. A method of coating components of a valve assembly (10), the method comprising:
hardening a spool outer surface (18) of a spool (20) to form a spool hardened surface having a surface roughness of less than or equal to 0.0001016 mm (0.000004 inches);
hardening a sleeve inner surface (16) of a sleeve (12) to form a sleeve hardened surface having a surface roughness of less than or equal to 0.0001016 mm (0.000004 inches); and
applying a diamond-like carbon coating on the hardened surface of at least one of the spool outer surface (18) and the sleeve inner surface (16); wherein
at least one of the sleeve (12) and the spool (20) are formed of a material comprising aluminum; and wherein
the hardened surface (24) comprises a base coating; and wherein
the coated valve assembly (10) comprises a fuel control metering valve.

10. The method of claim 9, wherein the diamond-like carbon coating is applied by a physical vapor deposition process.

## Patentansprüche

1. Beschichtete Ventilanordnung (10), umfassend:
eine Hülse (12) mit einer Hülsenaußenfläche (14) und einer Hülseninnenfläche (16);
eine Spule (20) mit einer Spulenaußenfläche (18);
eine gehärtete Fläche (24), die an der Hülseninnenfläche (16) und der Spulenaußenfläche (18) gebildet ist, und
eine Beschichtung (26), die an der gehärteten Fläche von wenigstens einer von der Spulenaußenfläche (18) und der Hülseninnenfläche (16) angeordnet ist, wobei die Beschichtung eine diamantartige Kohlenstoffbeschichtung umfasst; wobei
wenigstens eine von der Hülse (12) und der Spule (20) aus einem Material gebildet ist, das Aluminium umfasst; und wobei
die gehärtete Fläche (24) eine Basisbeschichtung umfasst; und wobei
die beschichtete Ventilanordnung (10) ein Kraftstoffeinspritzregelventil umfasst.

2. Beschichtete Ventilanordnung nach Anspruch 1, wobei die Beschichtung (26) nur an der Hülseninnenfläche (16) angeordnet ist.

3. Beschichtete Ventilanordnung nach Anspruch 1, wobei die Beschichtung (26) nur an der Spulenaußenfläche (18) angeordnet ist.

4. Beschichtete Ventilanordnung nach Anspruch 1, wobei die Beschichtung (26) sowohl an der Hülseninnenfläche (16) als auch an der Spulenaußenfläche (18) angeordnet ist.

5. Beschichtete Ventilanordnung nach Anspruch 1, wobei die gehärtete Fläche (24) eine gehärtete Flächendicke von 0,0254 mm (0,001 Zoll) bis 0,254 mm (0,010 Zoll) umfasst.

6. Beschichtete Ventilanordnung nach Anspruch 1, wobei die gehärtete Fläche (24) eine Oberflächenrauheit von weniger als oder gleich 0,000004 Zoll (0,0001016 mm) umfasst.

7. Beschichtete Ventilanordnung nach Anspruch 1, wobei die Beschichtung (26) eine Beschichtungsdicke von 0,00127 mm (0,000050 Zoll) bis 0,00635 mm (0,000250 Zoll) umfasst.

8. Beschichtete Ventilanordnung nach Anspruch 1, wobei die Basisbeschichtung eine Wärmesprühbeschichtung umfasst.

9. Verfahren zum Beschichten von Komponenten einer Ventilbaugruppe (10), wobei das Verfahren Folgendes umfasst:
Härten einer Spulenaußenfläche (18) einer Spule (20), um eine gehärtete Spulenfläche mit einer Oberflächenrauheit von weniger als oder gleich 0,0001016 mm (0,000004 Zoll) zu bilden;
Härten einer Hülseninnenfläche (16) einer Hülse (12), um eine gehärtete Hülsenfläche mit einer Oberflächenrauheit von weniger als oder gleich 0,0001016 mm (0,000004 Zoll) zu bilden; und
Aufbringen einer diamantartigen Kohlenstoffbeschichtung auf die gehärtete Fläche von wenigstens einer von der Spulenaußenfläche (18) und der Hülseninnenfläche (16); wobei
wenigstens eine von der Hülse (12) und der Spule (20) aus einem Material gebildet wird, das Aluminium umfasst; und wobei
die gehärtete Fläche (24) eine Basisbeschichtung umfasst; und wobei
die beschichtete Ventilbaugruppe (10) ein Kraftstoffeinspritzregelventil umfasst.

10. Verfahren nach Anspruch 9, wobei die diamantartige Kohlenstoffbeschichtung durch einen physikalischen Aufdampfprozess aufgebracht wird.

## Revendications

1. Système de soupape à revêtement (10) comprenant :
un manchon (12) ayant une surface extérieure de manchon (14) et une surface intérieure de manchon (16) ;
un tiroir (20) ayant une surface extérieure de tiroir (18) ;
une surface durcie (24) formée sur la surface intérieure de manchon (16) et la surface extérieure de tiroir (18) ; et
un revêtement (26) disposé sur la surface durcie d'au moins une parmi la surface extérieure de tiroir (18) et la surface intérieure de manchon (16), le revêtement comprenant un revêtement en carbone sous forme de diamant amorphe ; dans lequel
au moins un parmi le manchon (12) et le tiroir (20) sont formés d'un matériau comprenant de l'aluminium ; et dans lequel la surface durcie (24) comprend un revêtement de base ; et dans lequel
le système de soupape à revêtement (10) comprend une soupape de dosage de commande de carburant.

2. Système de soupape à revêtement selon la revendication 1, dans lequel le revêtement (26) est disposé uniquement sur la surface intérieure de manchon (16).

3. Système de soupape à revêtement selon la revendication 1, dans lequel le revêtement (26) est disposé uniquement sur la surface extérieure de tiroir (18).

4. Système de soupape à revêtement selon la revendication 1, dans lequel le revêtement (26) est disposé à la fois sur la surface intérieure de manchon (16) et la surface extérieure de tiroir (18).

5. Système de soupape à revêtement selon la revendication 1, dans lequel la surface durcie (24) comprend une épaisseur de surface durcie de 0,0254 mm (0,001 pouces) à 0,254 mm(0,010 pouces).

6. Système de soupape à revêtement selon la revendication 1, dans lequel la surface durcie (24) comprend une rugosité de surface inférieure ou égale à 0,000004 pouces (0,0001016 mm).

7. Système de soupape à revêtement selon la revendication 1, dans lequel le revêtement (26) comprend une épaisseur de revêtement de 0,00127 mm (0,000050 pouces) à 0,00635 mm (0,000250 pouces).

8. Système de soupape à revêtement selon la revendication 1, dans lequel le revêtement de base comprend un revêtement par projection thermique.

9. Procédé de revêtement de composants d'un système de soupape (10), le procédé comprenant les étapes consistant à :
durcir une surface extérieure de tiroir (18) d'un tiroir (20) pour former une surface durcie de tiroir ayant une rugosité de surface inférieure ou égale à 0,0001016 mm (0,000004 pouces) ;
durcir une surface intérieure de manchon (16) d'un manchon (12) pour former une surface durcie de manchon ayant une rugosité de surface inférieure ou égale à 0,0001016 mm (0,000004 pouces) ; et
appliquer un revêtement en carbone sous forme de diamant amorphe sur la surface durcie d'au moins une parmi la surface extérieure de tiroir (18) et la surface intérieure de manchon (16) ; dans lequel
au moins un parmi le manchon (12) et le tiroir (20) sont formés d'un matériau comprenant de l'aluminium ; et dans lequel
la surface durcie (24) comprend un revêtement de base ; et dans lequel
le système de soupape à revêtement (10) comprend une soupape de dosage de commande de carburant.

10. Procédé selon la revendication 9, dans lequel le revêtement en carbone sous forme de diamant amorphe est appliqué par un procédé de dépôt physique en phase vapeur.
